# EUROPÄISCHE PATENTSCHRIFT

(11) **EP 3 174 689 B1**
(45) Veröffentlichungstag und Bekanntmachung des Hinweises auf die Patenterteilung: **14.04.2021**
(21) Anmeldenummer: 15745164.2
(22) Anmeldetag: 14.07.2015
(51) Int. Cl.: B29C 67/00, B81C 99/00

(54) **MIKROMECHANISCHE KOMPONENTE UND VERFAHREN ZU IHRER HERSTELLUNG**
MICROMECHANICAL COMPONENT AND METHOD FOR PRODUCING SAME
COMPOSANT MICROMÉCANIQUE ET PROCÉDÉ DE FABRICATION

(30) Priorität: 31.07.2014 DE 102014215061
(43) Veröffentlichungstag der Anmeldung: 07.06.2017
(73) Patentinhaber: Fraunhofer-ges. zur Förderung der Angewandten Forschung E.V., 80686 München (DE)
(72) Erfinder: SCHIEBEL, Felix, 71638 Ludwigsburg (DE); EBERL, Christoph, 79346 Endingen (DE); BERWIND, Matthew, 79098 Freiburg (DE); GUMBSCH, Peter, 79194 Gundelfingen (DE)
(74) Vertreter: Friese Goeden Patentanwälte PartGmbB
(86) Internationale Anmeldenummer: PCT/EP2015/066064
(87) Internationale Veröffentlichungsnummer: WO 2016/015996

(56) Entgegenhaltungen:
- JP-A- S60 179 240
- US-A- 5 031 120
- US-A- 5 219 712

## Beschreibung

Die Erfindung betrifft ein Verfahren zur Herstellung mikromechanischer Komponenten, bei welchem ein flüssiges Ausgangsmaterial, welches durch Bestrahlung aushärtbar ist, auf ein Substrat aufgebracht wird, das Ausgangsmaterial durch lokale Bestrahlung mit einer ersten Bestrahlungsquelle in einem Teilvolumen ausgehärtet wird, um zumindest eine dreidimensionale Struktur zu erzeugen und das verbleibende flüssige Ausgangsmaterial zumindest teilweise entfernt wird. Weiterhin betrifft die Anmeldung eine mikromechanische Komponente, welche ein flüssiges Ausgangsmaterial enthält, welches teilweise durch Bestrahlung ausgehärtet wurde.

Aus der US 2012/0325775 A1 ist ein Verfahren zur Herstellung dreidimensionaler Mikrostrukturen bekannt. Bei diesem bekannten Verfahren wird ein flüssiges Material durch Belichtung mit einem fokussierten Laserstrahl ausgehärtet. Nach Abschluss der Belichtung kann das verbleibende flüssige Material entfernt werden, so dass die gewünschte mikromechanische Komponente auf dem Substrat verbleibt.

Dieses bekannte Verfahren weist jedoch den Nachteil auf, dass lediglich statische Strukturen erzeugt werden können. Eine nachträgliche Anpassung bzw. Nachbearbeitung der Komponenten ist ebenso ausgeschlossen wie die Herstellung beweglicher Komponenten Patentschrift JP 60-179240 A offenbart ein Verfahren gemäß dem Obergriff des Anspruchs 1.

Ausgehend von diesem Stand der Technik liegt der Erfindung die Aufgabe zugrunde, mikromechanische Komponenten und ein Verfahren zur deren Herstellung anzugeben, bei welchem eine einfache Nachbearbeitung der mikromechanischen Komponenten erfolgen kann und/oder welches mikromechanische Komponenten mit beweglichen Einzelteilen bereitstellen kann.

Die Aufgabe wird erfindungsgemäß durch ein Verfahren gemäß Anspruch 1 und eine mikromechanische Komponente gemäß Anspruch 9 gelöst. Vorteilhafte Ausgestaltungen der Erfindung finden sich in den Unteransprüchen.

Erfindungsgemäß wird vorgeschlagen, zur Herstellung mikromechanischer Komponenten ein flüssiges Ausgangsmaterial zu verwenden, welches durch Bestrahlung aushärtbar ist. Das Ausgangsmaterial kann in einigen Ausführungsformen der Erfindung ein an sich bekannter Fotolack sein, welche bei Bestrahlung polymerisiert. Der Fotolack kann ein Polymer enthalten, beispielsweise Polymethylmethacrylat und/oder Polymethylglutarimid. In anderen Ausführungsformen der Erfindung kann das Ausgangsmaterial zumindest ein Epoxydharz enthalten. Daneben kann das Ausgangsmaterial Lösungsmittel enthalten, beispielsweise Zyklopentanon oder γ-Butyrolactron.

Zur einfacheren Handhabbarkeit kann das Ausgangsmaterial zumindest während der Herstellung der mikromechanischen Komponente auf ein Substrat aufgebracht sein. Das Substrat kann in einigen Ausführungsformen der Erfindung ein Glas oder ein Halbleiter sein, beispielsweise ein Siliziumwafer. In anderen Ausführungsformen der Erfindung kann das Substrat Saphir enthalten oder daraus bestehen. Die mikromechanische Komponente kann nach deren Herstellung auf dem Substrat verbleiben, beispielsweise um die mikromechanische Komponente zusammen mit mikrooptischen und/oder mikroelektronischen Komponenten monolithisch zu integrieren. In anderen Ausführungsformen der Erfindung kann die mikromechanische Komponente nach ihrer Herstellung vom Substrat entfernt und separat weiterverarbeitet werden.

Zur Aushärtung des Ausgangsmaterials kann in einigen Ausführungsformen der Erfindung elektromagnetische Strahlung verwendet werden. Aufgrund ihrer hohen Brillanz kann Laserstrahlung aus einer ersten Lichtquelle zur Aushärtung des Ausgangsmaterials vorteilhaft eingesetzt werden. In anderen Ausführungsformen der Erfindung kann das Ausgangsmaterial durch einen Teilchenstrahl gehärtet werden, beispielsweise einen Elektronenstrahl oder einen Schwerionenstrahl.

Laserstrahlung kann in einigen Ausführungsformen der Erfindung eine Wellenlänge von etwa 2 µm bis etwa 0,2 µm aufweisen. In anderen Ausführungsformen der Erfindung kann die Laserstrahlung eine Wellenlänge von etwa 2 µm bis etwa 1 µm aufweisen. In diesem Fall kann die Aushärtung durch Mehrphotonenprozesse stimuliert werden, so dass der jeweils gehärtete Raumbereich auf den Fokuspunkt mit maximaler Intensität beschränkt werden kann. Auf diese Weise kann durch Veränderung der Fokuslage auch die Tiefe beeinflusst werden, in welcher das Ausgangsmaterial härtet. Zusammen mit einer translatorischen Bewegung des Lichtstrahles kann auf diese Weise eine dreidimensionale Struktur in das Ausgangsmaterial eingeschrieben werden.

Nachdem das flüssige Ausgangsmaterial durch Punkt-zu-Punkt-Schreiben in vorgebbaren Raumbereichen ausgehärtet wurde, kann das verbleibende flüssige Ausgangsmaterial zumindest teilweise entfernt werden.

Erfindungsgemäß wird nun vorgeschlagen, dass die dreidimensionale Struktur zumindest eine Kavität begrenzt, in welcher das flüssige Ausgangsmaterial eingeschlossen ist. Erfindungsgemäß wurde erkannt, dass das flüssige Ausgangsmaterial innerhalb der Kavität als Hydraulikfluid verwendet werden kann, um mikromechanische hydraulische Komponenten zu erzeugen. Auf diese Weise kann die mikromechanische Komponente beispielsweise ein hydraulischer Aktor und/oder Sensor sein oder einen solchen enthalten.

In anderen Ausführungsformen der Erfindung kann eine mikromechanische Komponente, welche eine vergleichsweise dünnwandige Kavität einschließt, nachträglich verformt werden, so dass sich in der Wandung eine mechanische Spannung ausbildet. In wiederum einer anderen Ausführungsformen der Erfindung kann eine mikromechanische Komponente, welche eine vergleichsweise dünnwandige Kavität einschließt, nachträglich verformt werden, so dass die Wandung sich zumindest teilweise an die Form einer benachbarten mikro- oder makromechanischen Komponente anpasst. Sofern eine dauerhafte Beweglichkeit nicht gewünscht oder nicht erforderlich ist, kann das flüssige Ausgangsmaterial im Inneren der Kavität nachträglich ausgehärtet bzw. polymerisiert werden, so dass die mikromechanische Komponente nur während ihrer Herstellung flüssiges Ausgangsmaterial in der Kavität enthält.

In einigen Ausführungsformen der Erfindung kann die Kavität zumindest ein Verstärkungselement enthalten. Das Verstärkungselement kann dazu vorgesehen sein, eine Verformung der mikromechanischen Komponente oder eine Verformung von zumindest einer Teilfläche einer Begrenzungswand der Kavität zu verhindern oder zu begrenzen. Hierdurch können mechanisch stabilere Strukturen erzeugt werden. Auch das Verstärkungselement kann in einigen Ausführungsformen der Erfindung durch Punkt-zu-Punkt-Belichten mit einem fokussierten Lichtstrahl aus einer ersten Lichtquelle in das flüssige Ausgangsmaterial eingeschrieben werden.

In einigen Ausführungsformen der Erfindung kann das flüssige Ausgangsmaterial in einem nachfolgenden Verfahrensschritt in die Gasphase überführt werden. Hierdurch kann die Kavität nicht nur mit flüssigem Ausgangsmaterial gefüllt sein, sondern zusätzlich oder alternativ auch mit einem Gas. Hierdurch kann in einigen Ausführungsformen der Erfindung die Kavität eine größere Elastizität und/oder eine veränderte Dämpfung aufweisen. In anderen Ausführungsformen der Erfindung kann das Gas als Hydraulikfluid verwendet werden, um einen mikromechanischen Aktor anzutreiben und/oder einen mikromechanischen Sensor zur realisieren. Das Überführen in die Gasphase kann in einigen Ausführungsformen durch Laserstrahlung erfolgen, welche die Moleküle des ursprünglich flüssigen Ausgangsmaterials dissoziiert und das Ausgangsmaterial damit zersetzt.

In einigen Ausführungsformen der Erfindung kann die Kavität von einer dünnen Membran begrenzt sein, welche in einem nachfolgenden Verfahrensschritt geöffnet und/oder durchstoßen wird. Hierdurch kann das Ausgangsmaterial zumindest teilweise aus der Kavität austreten.

In einigen Ausführungsformen der Erfindung kann das flüssige Ausgangsmaterial in einem nachfolgenden Verfahrensschritt durch Bestrahlung mit einer zweiten Strahlungsquelle ausgehärtet werden. Die zweite Strahlungsquelle kann ausgewählt sein aus einer Superlumineszenzdiode, einem defokussiertem Laserstrahl, einer Bogenlampe, einer Gasentladungslampe, natürlichem Sonnenlicht oder weiterer, hier nicht genannter Strahlungsquellen. Die zweite Strahlungsquelle kann einen vergleichsweise breiten Lichtkegel erzeugen und/oder eine geringere Wellenlänge aussenden als die erste Strahlungsquelle. Hierdurch kann das gesamte Volumen einer Kavität oder einer mikromechanischen Komponente gleichzeitig bestrahlt werden, so dass der gesamte Inhalt an flüssigem Ausgangsmaterial in einer oder mehreren Kavitäten rasch aushärtet. Hierdurch können vergleichsweise große mikromechanische Komponenten schneller und/oder einfacher hergestellt werden, da nur vergleichsweise dünne Begrenzungswände der Kavitäten und ggf. einzelne Verstärkungselemente durch Punkt-zu-Punkt-Belichtung mit Laserstrahlung hergestellt werden müssen. Nach Entfernen des flüssigen Ausgangsmaterials außerhalb der Kavitäten kann die mikromechanische Komponente durch großflächige Bestrahlung mit der zweiten Lichtquelle rasch vollständig ausgehärtet werden und so ihre endgültige Stabilität erhalten, ohne dass vergleichsweise dickwandige Strukturen aufwändig durch einen stark fokussierten Laserstrahl in das flüssige Ausgangsmaterial eingeschrieben werden müssen. Ebenso können geometrisch komplexe mikromechanische Komponenten nach Anpassung an eine gewünschte Endform durch großflächige Bestrahlung mit der zweiten Lichtquelle rasch in dieser Endform fixiert werden.

In einigen Ausführungsformen der Erfindung können zumindest zwei mikromechanische Komponenten formschlüssig gefügt werden. Hierzu kann eine dünnwandig begrenzte Kavität verwendet werden, welche sich an das zufügende Bauteil anschmiegt, ehe diese Form durch Aushärten des flüssigen Ausgangsmaterials innerhalb der Kavität fixiert wird.

In einigen Ausführungsformen der Erfindung können Strukturen mit unterschiedlichen Abmessungen miteinander verbunden werden. Sind diese hydraulisch und/oder mechanisch gekoppelt, können mit makroskopischen Werkzeugen, wie beispielsweise einer Pinzette oder einem Stab, mikroskopische Aktoren bedient werden.

Nachfolgend soll die Erfindung anhand von Figuren ohne Beschränkung des allgemeinen Erfindungsgedankens näher erläutert werden. Dabei zeigt
Fig. 1 einen Querschnitt durch eine mikromechanische Komponente in einer ersten Ausführungsform.
Fig. 2 zeigt den Querschnitt durch eine mikromechanische Komponente in einer zweiten Ausführungsform.
Fig. 3 zeigt einen hydraulischen Aktor als mögliches Anwendungsbeispiel der Erfindung.
Fig. 4 und Fig. 5 zeigen eine Mikrolinse mit variabler Brechkraft.
Fig. 6 erläutert die nachträgliche Formänderung einer mikromechanischen Komponente.
Fig. 7 erläutert die Verbindung zweier mikromechanischer Komponenten in einer ersten Ausführungsform.
Fig. 8 erläutert die Verbindung zweier mikromechanischer Komponenten in einer zweiten Ausführungsform.
Fig. 9 erläutert die Verbindung zweier mikromechanischer Komponenten in einer dritten Ausführungsform.
Fig. 10 illustriert die Erzeugung einer mechanischen Vorspannung in einer mikromechanischen Komponente.
Fig. 11 erläutert die Herstellung einer mikromechanischen Komponente aus mehreren Teilkomponenten.

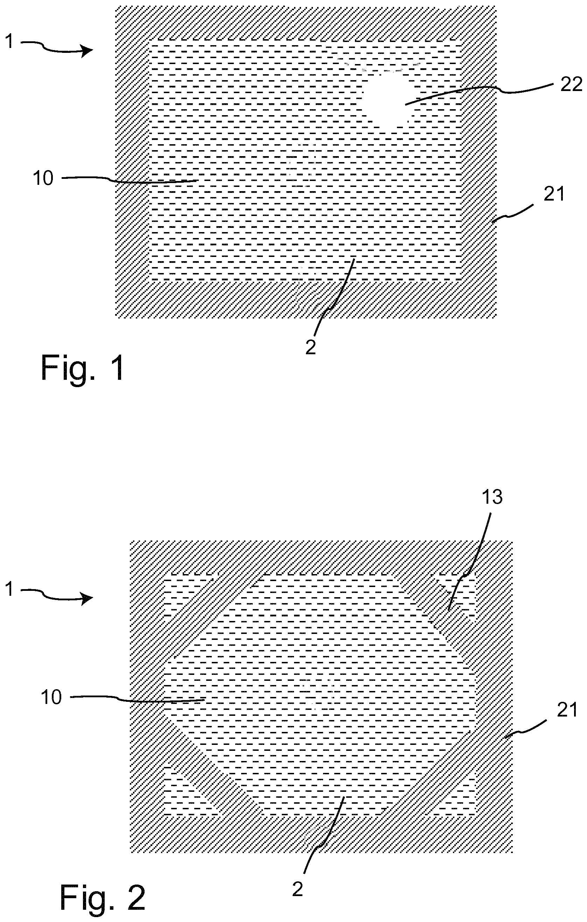

Fig. 1 zeigt den Querschnitt durch eine mikromechanische Komponente 1. Die mikromechanische Komponente 1 enthält im Wesentlichen eine quaderförmige Kavität 10. Die quaderförmige Kavität ist als Ausführungsbeispiel für die Grundform der vorliegenden Erfindung zu sehen. Mikromechanische Komponenten können in anderen Ausführungsformen komplexere Geometrien aufweisen, so dass diese den ihr zugedachten Zweck erfüllen können. Beispielsweise kann die Kavität andere polygonale, runde oder elliptische Querschnitte aufweisen.

Die mikromechanische Komponente wird aus flüssigem Ausgangsmaterial 2 erzeugt, welches durch Bestrahlung aushärtbar ist. Vorzugsweise wird elektromagnetische Strahlung verwendet welche auf einen Fokuspunkt fokussiert und durch eine erste Strahlungsquelle erzeugt wird. Der Strahl kann in der Ebene des das Ausgangsmaterial aufnehmenden Substrates verfahrbar sein, beispielsweise mit einem x-y-Tisch oder durch zumindest einen Ablenkspiegel. Auf diese Weise kann durch Wahl des Bestrahlungspunktes in der Ebene und durch Wahl der Fokuslage durch Punkt-zu-Punkt-Belichten eine dreidimensionale Struktur in das Ausgangsmaterial geschrieben werden.

In einigen Ausführungsformen der Erfindung polymerisiert das Ausgangsmaterial 2 durch kurzwellige sichtbare oder UV-Strahlung, so dass dieses durch die Bestrahlung gehärtet werden kann und sich polymerisiertes festes Ausgangsmaterial 21 bildet. In einigen Ausführungsformen der Erfindung wird eine erste Strahlungsquelle für infrarotes oder langwelliges sichtbares Licht verwendet, um durch Punkt-zu-Punkt-Belichten das Ausgangsmaterial 2 in vorgebbaren Raumbereichen zu verfestigen. In diesen Fällen wird die Polymerisation durch Mehrphotonenprozesse ausgelöst, so dass das Ausgangsmaterial bevorzugt am Fokuspunkt mit maximaler Intensität verfestigt wird und der übrige Strahlengang durch das Licht der ersten Strahlungsquelle weitgehend unbeeinflusst bleibt. Das verfestigte Material 21 umgrenzt die Kavität 10, in deren Inneren sich weiterhin flüssiges Ausgangsmaterial 2 befindet. Sofern die Kavität allseits geschlossen ist, ist das flüssige Ausgangsmaterial 2 innerhalb der Kavität eingeschlossen.

Je nach Anwendungszweck der mikromechanischen Komponente kann das flüssige Ausgangsmaterial 2 in der Kavität 10 zu einem späteren Zeitpunkt zur Aushärtung gebracht werden. Dies kann sehr rasch und effizient durch eine zweite Lichtquelle erfolgen, welche die mikromechanische Komponente 1 großflächig bestrahlt und kurzwelligere Strahlung aussendet, beispielsweise ultraviolette oder kurzwellige sichtbare Strahlung. In anderen Ausführungsformen der Erfindung kann das Ausgangsmaterial 2 in flüssiger Form innerhalb der Kavität 10 verbleiben, beispielsweise um eine Elastizität der mikromechanischen Komponente zu ermöglichen, um eine Schwingungsdämpfung der Eigenresonanzen des Materials zu kontrollieren oder um eine hydraulische Form- und/oder Volumenänderung der Kavität 10 zu bewirken. In wiederum einer anderen Ausführungsform der Erfindung kann das flüssige Ausgangsmaterial 2 durch Laserstrahlung dissoziiert und dadurch in einen gasförmigen Aggregatszustand umgewandelt werden. Hierdurch können Gaseinschlüsse 22 im Inneren der Kavität 10 gebildet werden. In einigen der Ausführungsformen der Erfindung kann das gesamte nach der Herstellung der Kavität dort eingeschlossene Volumen des flüssigen Ausgangsmaterials 2 dissoziiert werden, so dass die Kavität 10 ausschließlich mit einem Gas gefüllt ist. Dabei kann das Volumen der Flüssigkeit vor der Dissoziation geringer sein als das Volumen der Kavität. Durch die Gasfüllung kann sich der Druck und damit die Form der Kavität ändern oder das Dämpfungsverhalten beeinflusst werden oder der Widerstand gegen äußere Verformung beeinflusst werden

Fig. 2 zeigt eine weitere Ausführungsform der Erfindung. Auch in diesem Fall ist die mikromechanische Komponente 1 eine in etwa quaderförmige Kavität 10, welche lediglich beispielhaft die Funktion der vorliegenden Erfindung erläutert.

Die Ausführungsform gemäß Fig. 2 unterscheidet sich von der vorstehend beschriebenen Ausführungsform durch Verstärkungselemente 13, welche die mechanische Belastbarkeit der die Wandung der Kavität 10 bildenden Bereiche ausgehärteten Materials 21 erhöhen können. In einigen Ausführungsformen der Erfindung kann die Kavität 10 nur zeitweilig während der Herstellung der mikromechanischen Komponente mit flüssigem Ausgangsmaterial 2 gefüllt sein. Wird nämlich eine große mechanische Stabilität der mikromechanischen Komponente gefordert, so geht dies mit großen Wandstärken der die mikromechanische Komponente bildenden Strukturen einher. Die Punkt-zu-Punkt-Belichtung solcher Strukturen benötigt entsprechend hohe Prozesszeiten. Erfindungsgemäß wird daher in einer Ausführungsform vorgeschlagen, nur die äußere Umrandung und ggf. Verstärkungselemente 13 durch fokussierte Laserstrahlung im flüssigen Ausgangsmaterial zu erzeugen und das gesamte Volumen der Kavität 10 nachfolgend durch großflächige Bestrahlung zur Aushärtung zu bringen. Eine unerwünschte Verformung der mechanischen Komponente während der Herstellung und vor der vollständigen Aushärtung kann dabei durch Verstärkungselemente 13 verhindert werden, welche die Kavität 10 in einigen Ausführungsformen der Erfindung wie ein Fachwerk durchziehen.

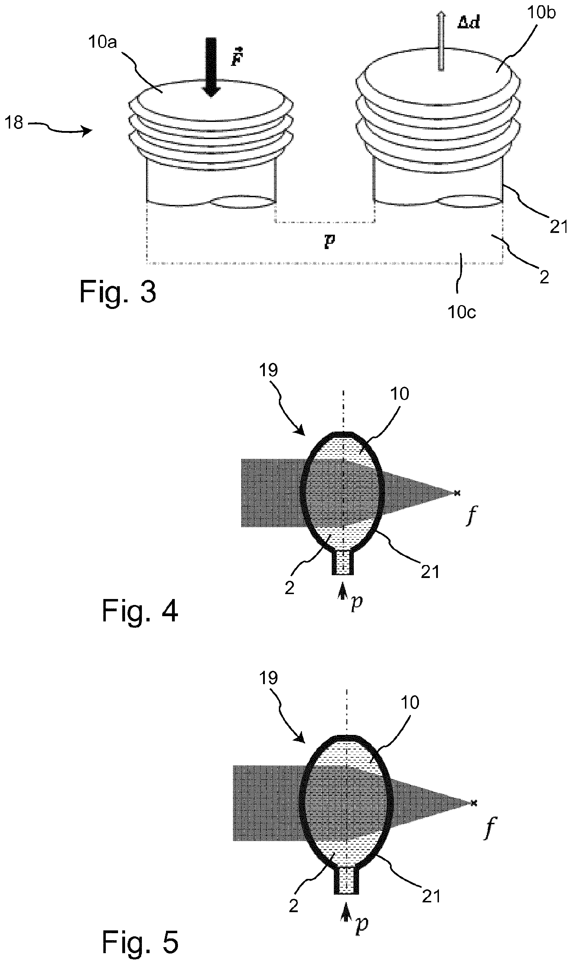

Fig. 3 zeigt ein hydraulisches Betätigungselement 18 als Ausführungsbeispiel für eine mikromechanische Komponente gemäß der vorliegenden Erfindung. Das hydraulische Betätigungselement 18 enthält eine erste Kavität 10a, eine zweite Kavität 10b und eine die beiden Kavitäten verbindende dritte Kavität 10c. Die drei Kavitäten 10a, 10b und 10c sind durch ausgehärtetes Material 21 begrenzt. Die Wandstärke des ausgehärteten Materials 21 kann in unterschiedlichen Teilflächen unterschiedlich gewählt sein, so dass die Begrenzungswände der Kavitäten entweder weitgehend formstabil oder aber verformbar sind. Auf diese Weise sind die Kavitäten 10a und 10b durch elastisch verformbare Begrenzungswände umschlossen, welche nach Art eines Federbalges verformbar sind. Die Kavität 10c ist weitgehend formstabil und ändert ihr Volumen nicht oder nur geringfügig. Wird nun eine Kraft F auf die obere Begrenzungsfläche 10a ausgeübt, führt dies zu einem Druckanstieg im Inneren der Kavität 10a und 10c, so dass sich die Kavität 10b vergrößert. Aufgrund der für die Begrenzungswände gewählten Geometrie erfolgt diese Volumenvergrößerung durch eine der Wirkung der Kraft F entgegengesetzte Bewegung der oberen Begrenzungsfläche der Kavität 10b um den Betrag Δd. Sofern auf die obere Begrenzungsfläche der Kavität 10b eine entsprechende Kraft ausgeübt wird, bewegt sich entsprechend die obere Begrenzungsfläche der Kavität 10a. Die in Fig. 3 dargestellte mikromechanische Komponente stellt somit ein hydraulisches Betätigungselement dar, welche das in den Kavitäten 10a, 10b und 10c eingeschlossene flüssige Ausgangsmaterial 2 als Hydraulikfluid verwendet.

In einigen Ausführungsformen der Erfindung kann die in Fig. 3 dargestellte mikromechanische Komponente eine Höhe von jeweils etwa 0,03 mm bis etwa 3 mm oder von etwa 0,1 mm bis etwa 1,0 mm aufweisen. In einigen Ausführungsformen der Erfindung kann die in Fig. 3 dargestellte mikromechanische Komponente eine Breite von etwa 0,02 mm bis etwa 10 mm oder von etwa 0,05 mm bis etwa 1,0 mm aufweisen. Kleine Details bzw. Strukturen können eine Strukturgröße von weniger als 0,8 µm oder weniger als 0,2 µm aufweisen.

Die Fig. 4 und 5 erläutern die Funktionsweise einer Linse 19 als Ausführungsbeispiel einer mikromechanischen Komponente 1. Die Linse 19 enthält wiederum eine Kavität 10, welche durch ausgehärtetes Ausgangsmaterial 21 umgrenzt ist. Die Kavität 10 ist mit flüssigem Ausgangsmaterial 2 gefüllt. Die Begrenzungswand der Kavität 10 weist eine Krümmung auf, so dass durch die Linse hindurchtretende elektromagnetische Strahlung auf einem Fokuspunkt f fokussiert wird.

Wie Fig. 5 zeigt, kann durch Erhöhen des Druckes des flüssiges Ausgangsmaterials 2 in der Kavität 10 eine weitere Verformung der Begrenzungsflächen der Linse 19 erzielt werden, so dass die Krümmung der Begrenzungsflächen ansteigt und die Brechkraft der Linse 19 vergrößert wird. Hierdurch ändert sich die Lage des Fokuspunktes f. Die erfindungsgemäße Linse 19 kann als fokussierbare Mikrolinse verwendet werden, so dass die Brechzahl der Linse im laufenden Betrieb angepasst werden kann. In anderen Ausführungsformen der Erfindung kann die Brechkraft einmalig durch Anpassen des Innendruckes auf einen gewünschten Wert eingestellt werden und durch nachfolgendes Belichten und Aushärten des flüssigen Ausgangsmaterials 2 im Inneren der Kavität 10 in dieser Stellung fixiert werden.

In einigen Ausführungsformen der Erfindung kann die in den Fig. 4 und 5 dargestellte mikromechanische Linse einen Durchmesser von etwa 0,1 mm bis etwa 1 mm oder von etwa 0,3 mm bis etwa 0,8 mm aufweisen. Die Linse kann mit weiteren optischen oder elektronischen Komponenten auf einem Substrat zu einem mikrooptischen Chip integriert werden.

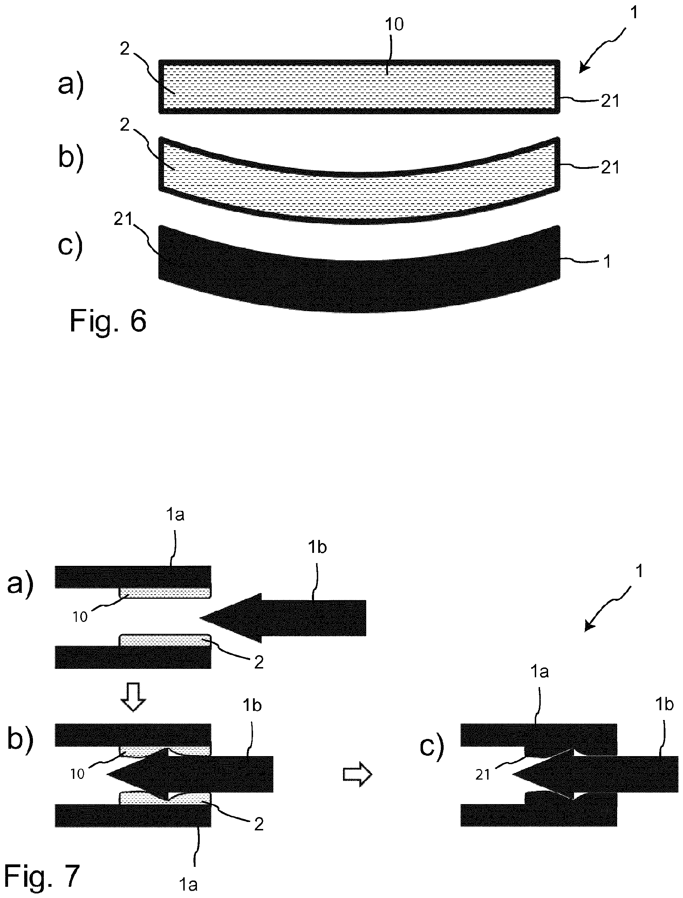

Fig. 6 zeigt die nachträgliche Anpassung der Form einer mikromechanischen Komponente.

Als exemplarisches Ausführungsbeispiel ist in Figur 6a wiederum eine mikromechanische Komponente in Form eines rechteckigen Quaders gezeigt, welcher eine Kavität 10 aufweist. Die Kavität 10 ist durch ausgehärtetes Ausgangsmaterial 21 umgrenzt und mit flüssigem Ausgangsmaterial 2 gefüllt. Nach Herstellen der mikromechanischen Komponente 1 durch Punkt-zu-Punkt-Belichten der Umgrenzungswand und Entfernen des verbleibenden flüssigen Ausgangsmaterials 2 im Außenbereich rund um die mikromechanische Komponente kann die Form an eine gewünschte Sollform angepasst werden.

Fig. 6b zeigt exemplarisch die Wölbung des zunächst rechteckigen Querschnittes, so dass sich beispielsweise die Form einer Zylinderlinse ergibt. In anderen Ausführungsformen der Erfindung kann die Formänderung auch dazu dienen, einen Formschluss zu einem benachbarten Bauteil herzustellen oder eine mechanische Spannung in einer Begrenzungsfläche der mechanischen Komponente zu induzieren oder die relative Lage zweier Bauteile zu beeinflussen.

Fig. 6c zeigt die mikromechanische Komponente 1, nachdem der gesamte Inhalt der Kavität 10 durch großflächiges Belichten mit einer Strahlungsquelle ausgehärtet wurde. Da die Verformbarkeit der mikromechanischen Komponente im zweiten Verfahrensschritt wesentlich darauf beruht, dass die Begrenzungswände der Kavität nur dünnwandig und damit mechanisch wenig stabil sind und das flüssige Ausgangsmaterial 2 in der Kavität 10 keine Scherkräfte übertragen kann, kann die mikromechanische Komponente 1 nach Durchführung des dritten Verfahrensschrittes in dieser Form fixiert werden, so dass eine nachträgliche unerwünschte Verformung vermieden wird.

Fig. 7 erläutert das Herstellen einer formschlüssigen Verbindung zwischen zwei mikromechanischen Komponenten 1a und 1b. Die mikromechanische Komponente 1a weist eine Durchgangs- oder Sackbohrung auf, an deren Innenseite eine Kavität 10 ausgeformt ist, welche flüssiges Ausgangsmaterial 2 einschließt. Die Wandung der Kavität 10 ist dünnwandig ausgeführt, so dass die Wandung verformbar ist.

Die zweite Komponente 1b ist im Ausführungsbeispiel pfeilförmig dargestellt. In anderen Ausführungsformen der Erfindung kann selbstverständlich eine andere Form gewählt werden. Wesentlich ist lediglich, dass ein Teilbereich in die Ausnehmung der Komponente 1a einführbar ist und dort eine Verbreiterung aufweist, welche zur Verformung der Begrenzungswand der Kavität 10 führt. Dieser Zustand ist in Fig. 7b dargestellt. Es ist erkennbar, dass sich die Begrenzungswand der Kavität 10 an den Schaft der Komponente 1b anschmiegt, wobei die vorstehende Teile wie Widerhaken wirken. In der in Fig. 7b dargestellten Stellung ist noch eine einfache Korrektur der relativen Lage der Komponenten 1a und 1b möglich, da das flüssige Ausgangsmaterial 2 in der Kavität 10 keine Scherkräfte übertragen kann und bei relativer Lageänderung damit die Komponente 1b eine andere Position innerhalb der Komponente 1a einnehmen kann.

Nachdem die Endposition bzw. die endgültige relative Lage der beiden Komponenten 1a und 1b gefunden wurde, kann durch optionales Ausbelichten des flüssigen Ausgangsmaterials 2 eine feste, formschlüssige und dabei spannungsarme Verbindung zwischen dem Komponenten 1a und 1b hergestellt werden.

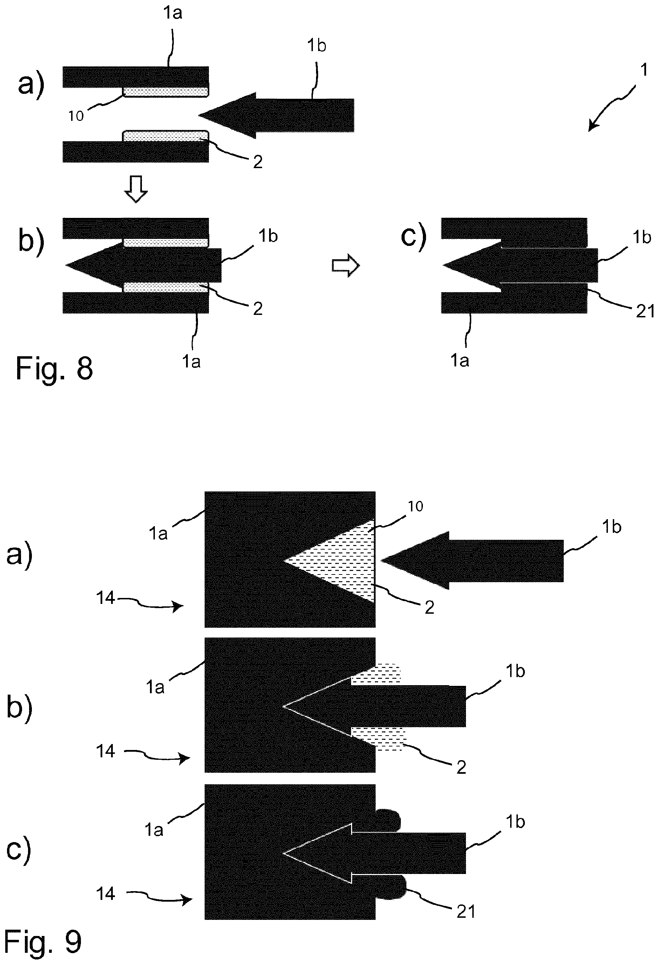

Fig. 8 zeigt ein zweites Ausführungsbeispiel einer formschlüssigen Verbindung zwischen zwei mikromechanischen Komponenten 1a und 1b. Gleiche Bestandteile der Erfindung sind mit gleichen Bezugszeichen versehen, so dass sich die nachfolgende Beschreibung auf die wesentlichen Unterschiede beschränkt. Wie Fig. 8b zeigt, wird die Komponente 1b soweit in die Ausnehmung der Komponente 1a eingeschoben, dass die Begrenzungsflächen der Kavität 10 vollflächig am Schaft der Komponente 1b anliegen. Auf diese Weise nimmt die Kavität 10 nach dem Einführen der Komponente 1b wieder ihre ursprüngliche Form an. Nach dem optionalen Aushärten des flüssigen Ausgangsmaterials 2 durch Belichten der Kavität 10 ergibt sich so die in Fig. 8c gezeigte vollständig spannungsfreie Befestigung der Komponente 1b in der Komponente 1a. Darüber hinaus kann eine axiale Verschiebbarkeit der Komponente 1b bestehen bleiben, ohne dass jedoch die Komponente 1b von der Komponente 1a getrennt werden kann.

Fig. 9 zeigt eine dritte Ausführungsform eines Verbindungselementes gemäß der vorliegenden Erfindung. Auch in diesem Fall soll eine Komponente 1a und eine Komponente 1b dauerhaft miteinander verbunden werden. Wie in Fig. 9a ersichtlich, wird in der Komponente 1a eine Kavität gefertigt, deren Form in einigen Ausführungsformen der Erfindung komplementär zu einem Teilbereich der Komponente 1b ist. Die Kavität 10 ist mit einer dünnen Membran aus verfestigtem Ausgangsmaterial verschlossen, um das Austreten flüssigen Ausgangsmaterials 2 aus der Kavität zu verhindern.

Fig. 9b zeigt, wie die Membran beim Einführen der Komponente 1b in die Kavität 10 durchstoßen und das flüssige Ausgangsmaterial dadurch aus der Kavität 10 zumindest teilweise verdrängt wird. Das flüssige Ausgangsmaterial 10 haftet in der Kavität 10 und an der Komponente 1b im Bereich der Fügestelle. Durch Belichten des flüssigen Ausgangsmaterials 2 verfestigt dies, so dass das verfestigte Ausgangsmaterial 21 eine sichere und spannungsfreie Verbindung der beiden Komponenten 1a und 1b bewirkt.

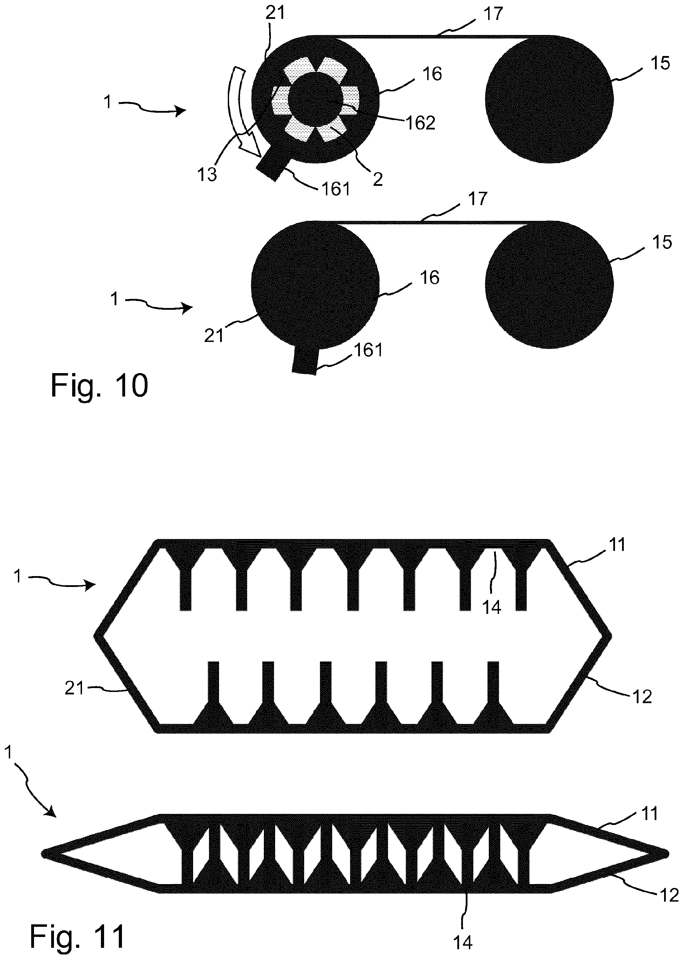

Fig. 10 zeigt beispielhaft, wie in eine mikromechanische Komponente 1 während des Herstellungsverfahrens dauerhaft eine mechanische Spannung eingeprägt werden kann. Beispielhaft ist eine Saite oder eine Folie 17 gezeigt, welche über zwei Spannelemente 15 und 16 vorgespannt wird.

Das erste Spannelement 15 besteht im Wesentlichen aus ständig ausgehärtetem Ausgangsmaterial 21, welches durch lokales Belichten mit einer Strahlungsquelle aus flüssigem Ausgangsmaterial erzeugt wird.

In gleicher Weise wird die Saite, bzw. das Flächenelement 17 durch Belichten mit einer fokussierbaren Strahlungsquelle im flüssigen Ausgangsmaterial erzeugt.

Das zweite Spannelement 16 weist eine feststehende Achse 162 auf. Der äußere Teil des Spannelements 16 steht über Verstärkungselemente 13 punktförmig mit der Achse 162 in Kontakt, so dass sich zwischen dem äußeren Teil des Spannelements und der Achse 162 Kavitäten ausbilden, welche mit flüssigem Ausgangsmaterial 2 gefüllt sind, wobei der äußere Teil des Spannelements um die Achse 162 drehbar ist.

Weiterhin weist das äußere Spannelement 16 einen Hebel 161 auf. Durch Aufprägen einer Kraft am Hebel 161 kann das äußere Spannelement 16 um die Achse 162 gedreht werden, so dass die Punktkontakte der Verstärkungselemente 13 an der Achse 162 abbrechen und eine mechanische Spannung auf das Element 17 aufgeprägt wird. Nach Erreichen des gewünschten Wertes kann das Material 2 in den Kavitäten durch Belichten ausgehärtet werden, so dass das Spannelement 16 in dieser Stellung fixiert ist. Dadurch ist die mechanische Spannung im Element 17 dauerhaft aufgeprägt.

Fig. 11 zeigt eine mechanische Komponente 1, welche aus einer ersten Teilstruktur 11 und einer zweiten Teilstruktur 12 zusammengesetzt ist. Hierdurch kann die Strukturgröße der mechanischen Komponente 1 nach Fertigstellung geringer sein, als üblicherweise durch das Herstellungsverfahren ermöglicht wird, indem die Strukturierung der einen Teilkomponente in die Zwischenräume der Strukturierungen der anderen Teilkomponente eingreift. Die mechanische Komponente 1 gemäß Fig. 11 kann beispielsweise als Filter für Oberflächenwellen oder Mikrowellen verwendet werden.

Zur dauerhaften Verbindung der beiden Teilstrukturen 11 und 12 können beispielsweise die in Fig. 9 gezeigten Verbindungselemente 14 verwendet werden.

Selbstverständlich ist die Erfindung nicht auf die in den Figuren dargestellten Ausführungsformen beschränkt. Die vorstehende Beschreibung ist daher nicht als beschränkend sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Soweit die Ansprüche und die vorstehende Beschreibung "erste" Und "zweite" Merkmale definieren, so dient diese Bezeichnung der Unterscheidung zweier gleichartiger Merkmale, ohne eine Rangfolge festzulegen.

## Patentansprüche

1. Verfahren zur Herstellung mikromechanischer Komponenten (1), bei welchem
ein flüssiges Ausgangsmaterial (2), welches durch Bestrahlung aushärtbar ist, auf ein Substrat aufgebracht wird, und
das Ausgangsmaterial durch lokale Bestrahlung mit einer ersten Strahlungsquelle in einem Teilvolumen (21) ausgehärtet wird, um zumindest eine dreidimensionale Struktur zu erzeugen,
**dadurch gekennzeichnet, dass**
die dreidimensionale Struktur zumindest eine geschlossene Kavität (10) begrenzt, in welcher zumindest ein Teil des flüssigen Ausgangsmaterials (2) eingeschlossen ist, wobei
die Strahlung auf einen Fokuspunkt fokussiert wird und durch Wahl der Fokuslage durch Punkt-zu-Punkt-Belichten eine dreidimensionale Struktur in das Ausgangsmaterial geschrieben wird.

2. Verfahren nach Anspruch 1, **dadurch gekennzeichnet, dass** die Kavität (10) zumindest ein Verstärkungselement (13) enthält.

3. Verfahren nach Anspruch 1 oder 2, **dadurch gekennzeichnet, dass** das in der Kavität (10) eingeschlossene flüssige Ausgangsmaterial (2) in einem nachfolgenden Verfahrensschritt in die Gasphase (22) überführt wird

4. Verfahren nach einem der Ansprüche 1 oder 2, **dadurch gekennzeichnet, dass** das in der Kavität (10) eingeschlossene flüssige Ausgangsmaterial (2) in einem nachfolgenden Verfahrensschritt durch Bestrahlung mit einer zweiten Strahlungsquelle ausgehärtet wird.

5. Verfahren nach einem der Ansprüche 1 oder 2, **dadurch gekennzeichnet, dass** das in der Kavität (10) eingeschlossene flüssige Ausgangsmaterial (2) in einem nachfolgenden Verfahrensschritt unter Druck gesetzt wird, um die Kavität (10) zu verformen.

6. Verfahren nach einem der Ansprüche 3 oder 5, **dadurch gekennzeichnet, dass** in dem ausgehärteten Ausgangsmaterial (21) der mikromechanischen Komponente (1) eine mechanische Spannung erzeugt wird.

7. Verfahren nach einem der Ansprüche 3 bis 6, **dadurch gekennzeichnet, dass** zumindest zwei mikromechanische Komponenten (1a, 1b) formschlüssig gefügt werden.

8. Verfahren nach einem der Ansprüche 1 bis 7, **dadurch gekennzeichnet, dass** zur Herstellung der mikromechanischen Komponente (1) ein erstes Teilelement (11) mit einer ersten Stuktur und ein zweites Teilelement (12) mit einer zweiten Struktur zusammengefügt werden.

9. Mikromechanische Komponente (1), welche ein flüssiges Ausgangsmaterial (2) enthält, welches teilweise durch Bestrahlung ausgehärtet ist, und welche zumindest eine geschlossene Kavität (10) enthält, in welcher das flüssige Ausgangsmaterial (2) eingeschlossen ist.

10. Komponente nach Anspruch 9, **dadurch gekennzeichnet, dass** die Kavität (10) zumindest ein Verstärkungselement (13) enthält.

11. Komponente nach einem der Ansprüche 9 oder 10, **dadurch gekennzeichnet, dass** diese zumindest ein hydraulisches Betätigungselement (18) und/oder zumindest eine Linse (19) und/oder zumindest ein Verbindungselement enthält.

12. Komponente nach einem der Ansprüche 9 bis 11, **dadurch gekennzeichnet, dass** das durch Bestrahlung ausgehärtete Material der Komponente (1) in zumindest einem Teilbereich (17) eine mechanische Spannung aufweist.

13. Komponente nach einem der Ansprüche 9 bis 12, **dadurch gekennzeichnet, dass** diese ein Metamaterial enthält, welches eine Mehrzahl von Kavitäten (10) enthält, welche jeweils mit dem flüssigen Ausgangsmaterial (2) gefüllt sind.

## Claims

1. Method for producing micromechanical components (1), in which
a liquid starting material (2), which can be cured by irradiation, is applied onto a substrate, and
the starting material is cured by local irradiation using a first radiation source in a partial volume (21) in order to produce at least one three-dimensional structure,
**characterized in that**
the three-dimensional structure delimits at least one closed cavity (10), which encloses at least part of the liquid starting material (2), wherein the radiation is focused on a focal point and by selecting the focal position a three-dimensional structure is written into the starting material by point-to-point exposure.

2. Method according to claim 1, **characterized in that** the cavity (10) contains at least one reinforcing element (13).

3. Method according to claim 1 or 2, **characterized in that** the liquid starting material (2) enclosed in the cavity (10) is converted into the gas phase (22) in a subsequent method step.

4. Method according to any of claims 1 or 2, **characterized in that** the liquid starting material (2) enclosed in the cavity (10) is cured in a subsequent method step by irradiation using a second radiation source.

5. Method according to any of claims 1 or 2, **characterized in that** the liquid starting material (2) enclosed in the cavity (10) is pressurized in a subsequent method step in order to deform the cavity (10).

6. Method according to any of claims 3 or 5, **characterized in that** a mechanical tension is produced in the cured starting material (21) of the micromechanical component (1).

7. Method according to any of claims 3 to 6, **characterized in that** at least two micromechanical components (1a, 1b) are joined in positive engagement.

8. Method according to any of claims 1 to 7, **characterized in that** a first partial element (11) having a first structure and a second partial element (12) having a second structure are joined in order to produce the micromechanical component (1).

9. Micromechanical component (1), which contains a liquid starting material (2), part of which is cured by irradiation, and which contains at least one closed cavity (10) enclosing the liquid starting material (2).

10. Component according to claim 9, **characterized in that** the cavity (10) contains at least one reinforcing element (13).

11. Component according to any of claims 9 or 10, **characterized in that** it has at least one hydraulic actuating element (18) and/or at least one lens (19) and/or at least one connecting element.

12. Component according to any of claims 9 to 11, **characterized in that** the irradiation-cured material of component (1) has a mechanical tension in at least one partial area (17).

13. Component according to any of claims 9 to 12, **characterized in that** it contains a metamaterial which contains a plurality of cavities (10) that are all filled with the liquid starting material (2).

## Revendications

1. Procédé de fabrication de composants micromécaniques (1), dans lequel un matériau de départ (2) liquide qui peut être durci par irradiation est appliqué sur un substrat, et
le matériau de départ est durci par irradiation locale avec une première source de rayonnement dans un volume partiel (21) pour produire au moins une structure tridimensionnelle,
**caractérisé en ce que**
la structure tridimensionnelle délimite au moins une cavité fermée (10) dans laquelle est enfermée une partie au moins du matériau de départ (2) liquide,
le rayonnement étant focalisé sur un point focal et une structure tridimensionnelle étant inscrite dans le matériau de départ par exposition point à point par sélection de la position focale.

2. Procédé selon la revendication 1,
**caractérisé en ce que** la cavité (10) contient au moins un élément de renforcement (13).

3. Procédé selon la revendication 1 ou 2,
**caractérisé en ce que** le matériau de départ (2) liquide enfermé dans la cavité (10) est transféré en phase gazeuse (22) lors d'une étape suivante du procédé.

4. Procédé selon l'une des revendications 1 ou 2,
**caractérisé en ce que** le matériau de départ (2) liquide enfermé dans la cavité (10) est durci dans une étape suivante du procédé par irradiation avec une seconde source de rayonnement.

5. Procédé selon l'une des revendications 1 ou 2,
**caractérisé en ce que** le matériau de départ (2) liquide enfermé dans la cavité (10) est pressurisée dans une étape suivante du procédé pour déformer la cavité (10).

6. Procédé selon l'une des revendications 3 ou 5,
**caractérisé en ce qu'**une contrainte mécanique est générée dans le matériau de départ (2) durci du composant micromécanique (1).

7. Procédé selon l'une des revendications 3 à 6,
**caractérisé en ce qu'**au moins deux composants micromécaniques (1a, 1b) sont assemblés l'un à l'autre par coopération de forme.

8. Procédé selon l'une des revendications 1 à 7,
**caractérisé en ce que**, pour fabriquer le composant micromécanique (1), un premier élément partiel (11) ayant une première structure et un second élément partiel (12) ayant une seconde structure sont assemblés l'un à l'autre.

9. Composant micromécanique (1) qui contient un matériau de départ (2) liquide durci partiellement par irradiation et qui présente au moins une cavité fermée (10) dans laquelle est enfermé le matériau de départ (2) liquide.

10. Composant selon la revendication 9,
**caractérisé en ce que** la cavité (10) contient au moins un élément de renforcement (13).

11. Composant selon l'une des revendications 9 ou 10,
**caractérisé en ce qu'**il comprend au moins un élément d'actionnement hydraulique (18) et/ou au moins une lentille (19) et/ou au moins un élément de liaison.

12. Composant selon l'une des revendications 9 à 11,
**caractérisé en ce que** le matériau du composant (1) durci par irradiation présente une contrainte mécanique dans au moins une zone partielle (17).

13. Composant selon l'une des revendications 9 à 12,
**caractérisé en ce qu'**il comprend un méta-matériau présentant une pluralité de cavités (10) remplies chacune avec le matériau de départ (2) liquide.
